# EUROPEAN PATENT SPECIFICATION

(11) **EP 2 857 851 B1**
(45) Date of publication and mention of the grant of the patent: **07.08.2019**
(21) Application number: 13187220.2
(22) Date of filing: 03.10.2013
(51) Int. Cl.: G01R 31/07, G01R 31/327

(54) **A device for diagnosing the condition of a fuse or a contact in a contactor and electromechanical assembly comprising such a diagnosing device**
Vorrichtung zur Diagnose des Zustands einer Sicherung oder eines Kontakts in einem Schütz und elektromechanische Anordnung mit einer solchen Diagnosevorrichtung
Dispositif de diagnostic de l'état d'un fusible ou contact dans un contacteur et ensemble électromécanique comprenant un tel dispositif de diagnostic

(43) Date of publication of application: 08.04.2015
(73) Proprietor: Fico Triad, S.A., 08232 Viladecavalls (ES)
(72) Inventor: Sala, Enric, 08232 VILADECAVALLS (ES)
(74) Representative: ZBM Patents - Zea, Barlocci & Markvardsen

(56) References cited:
- FR-A1- 2 689 677
- US-A- 3 822 398
- US-A- 4 382 225
- US-A1- 2007 047 161

## Description

A device for determining the condition of a contact in a contactor or a fuse such as a relay is disclosed herein. An electromechanical assembly comprising such a diagnosing device is also disclosed herein.

### BACKGROUND ART

Devices for determining the condition of a contact in a contactor or a fuse are known in the art. Such devices include circuitry having divider resistors intended for potential measurement. In the case of high-voltage circuits this must be carried through multiple resistors arranged in series to adjust the measurement range, an isolation circuit to separate the high voltage potential (contact measurement) of the control circuit through the use of DC/DC converters and isolated buffers, and disconnect switches of the measuring resistor chain to avoid current to be permanently drawn.

Known devices are based on measuring the electrical potential on both sides of the contact in a contactor. If different electrical potentials are measured on both sides of the contact, its condition is determined to be off. If the same electrical potential is measured on both sides of the contact, its condition is determined to be on. As used herein, an "on condition" means a closed contact or a correct fuse. As used herein an "off condition" means an open contact or a blown fuse.

However, there may be an indeterminate condition in which the condition of the contact is determined to be either an on condition or a coincidence of potentials in off condition. It is therefore a likely but not certain detection so it can not be guaranteed that current is flowing in the on condition detected. In addition, there are cases in which one side of the contact has a floating potential (open-air cable, not connected to any place), resulting in that measuring of potential is not suitable.

Another problem with the presently known devices is that when detecting the condition of a contact of a contactor, the contact itself to be diagnosed is usually connected to electrical potentials that are different from those of the measuring circuit. Eventually these electrical potentials may be high voltage potentials and therefore isolated circuits are required which renders the device more complex.

Document FR2689677 discloses a device for monitoring the state of a fuse by supplying a constant current for powering the fuse to be tested. A measuring circuit is provided for measuring current across the fuse to test the voltage drop caused by the constant current across the fuse. A displaying circuit us provided for calculating and displaying the fuse state that is determined by comparing its actual resistance of the fuse with that of an undamaged fuse.

### SUMMARY

A device according to claim 1 for diagnosing the condition of a fuse or a contact in a contactor such as an electromechanical relay is disclosed herein. This device comprises an current generator adapted to deliver a pilot current through the fuse or contact to be diagnosed, and a computing/electronic module for verifying if the delivered pilot current flows through the fuse or contact. Such diagnosing device is thus capable of determining if the fuse or contact is either in an on or in an off condition as defined above, that is, if there is a closed contact or operating fuse or if there is an open contact or blown fuse, respectively.

The current generator is arranged such that the supply of the pilot current reflected at the primary side of a transformer is suitably isolated from the supply of main current to the fuse or contact.

On the other hand, the computing/electronic module may comprise at least one selected from electronic module, computing module and logic gate module or any combination of them. This way, for example, the computing/electronic module could be a programmable electronic device such as an ASIC, an FPGA or a programmable controller or may be a computing device, which may comprise a memory and a processor, the memory being adapted to store computer program instructions and the processor being adapted to execute instructions stored in the memory with the purpose of generating the different events and actions for which the computing/electronic module is programmed.

According to an embodiment the second sub-module may comprise a set of transistors that is provided in the primary windings of the transformer; and the third sub-module may comprise at least one condenser that is provided in the secondary windings of the transformer.

The present diagnosing device may further include a microcontroller connected to the outlet of the computing/electronic module for controlling said transistors. This microcontroller is capable of controlling the transistors alternatively such as in a pulse width modulation (PWM) mode, for example with a 90° phase shift.

The present diagnosing device may have means for assessing a pilot current that is a replica of the pilot current through the contact to be diagnosed, through the transformer ratio. That is, the pilot current flowing in the contact to be diagnosed is transformed by the transformer ratio so that it can be assessed at the microcontroller side.
adapted to assess the impedance of the pilot current supplied to the contact to be diagnosed. In this way, if a threshold maximum value of such impedance is detected an indication is given that the contact is in an off condition, otherwise an indication is given that the contact is in an on condition, as defined above.

The present diagnosing device has a great number of applications. For example, after sending an opening or closing command to a command coil, the device allows, by determining the connection condition, such commands to be accurately checked if they were successful performed. This is carried out by checking the condition of the corresponding contact. Similarly, the condition of a fuse can be diagnosed by the present diagnosing device assuming that a correct fuse behaves like a closed contact (current can flow), while a blown fuse behaves like an open contact (current can not flow).

In general, the present device can be applied to assemblies having electromechanical relays and/or fuses, in which a diagnosis of the condition of the components is desired. For example, an interesting application of the present device is for battery junction boxes in electric vehicles, where relays and fuses are safety components for high voltage battery disconnection.

The present device is capable of sensing in advance the condition of contacts or fuses, regardless of their electrical potential to terminals, even before coming into service (before undergoing an electrical potential).

Further advantages of the present device are that real flow of current through a contact can be simulated instead of using potential references as in the prior art which may result in indefinite or floating states. In addition, the circuit to be diagnosed may be out of service, that is, not connected to their main voltage, so that a previous reading is allowed. By contrast, in the prior art the circuit to be diagnosed should be in operation with corresponding potentials properly set. Finally, also an important advantage of the present device is its simplicity in contrast to complex prior art devices using voltage dividers, isolated measuring circuits, optocouplers.

An electromechanical assembly is also disclosed comprising the above described device for diagnosing the condition of a fuse or a contact in a contactor.

Additional objects, advantages and features of embodiments of the present device and assembly will become apparent to those skilled in the art upon examination of the description, or may be learned by practice thereof.

### BRIEF DESCRIPTION OF THE DRAWINGS

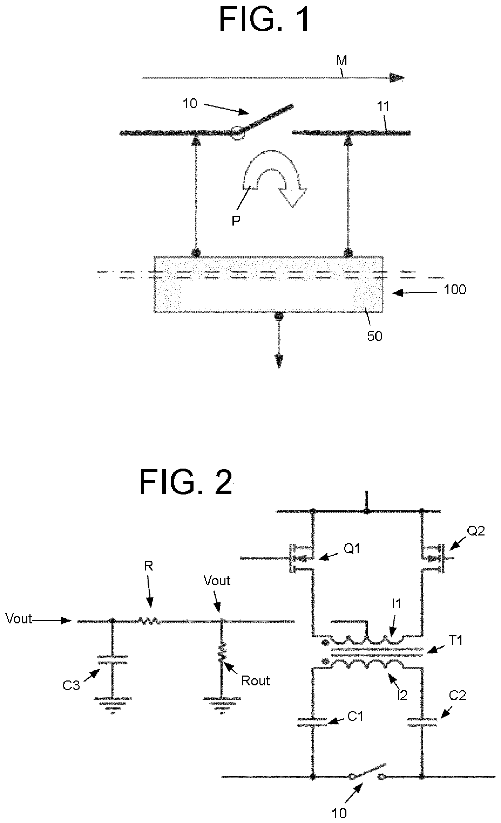

Particular embodiments of the present device will be described in the following by way of non-limiting examples, with reference to the appended drawings, in which figures 1 and 2 are circuit diagrams showing the operation of the present device for diagnosing the condition of a fuse or a contact in a contactor.

### DETAILED DESCRIPTION OF EMBODIMENTS

According to figure 1 that diagrammatically shows the operation of the present device, a fuse or a contact 10 to be diagnosed is provided in a line 11 through which a main current M can flow.

The present diagnosing device 100 specifically shown in figure 2 can be used, for example, for determining the connection condition of contact 10 after sending an opening and/or closing command to a command coil or for determining the condition of a fuse 10 on the assumption that an operating fuse behaves like a closed contact while a blown fuse behaves like an open contact.

The present diagnosing device 100 comprises a current generator 50. The current generator 50 is adapted to deliver a pilot current P through the fuse or contact 10 to be diagnosed. The current generator 50 is arranged such that the supply of the pilot current P reflected at the primary side of the transformer is suitably isolated from the supply of main current M to the fuse or contact 10.

The diagnosing device 100 shown further comprises a computing/electronic module. The computing/electronic module serves the purpose of verifying if the pilot current P flows through the fuse or contact 10 and therefore to determine if the fuse or contact 10 is either in an on condition or in an off condition.

The computing/electronic module may comprise one or more of an electronic module, a computing module and logic gate module. In general, it comprises a transformer T1 intended for separating potentials between the fuse or contact 10 to be diagnosed and said computing/electronic module.

The computing/electronic module further comprises a number of transistors Q1, Q2 provided in the primary windings of transformer T1. Transistors Q1, Q2 may be controlled through the above computing/electronic module. The diagnosing device 100 of the specific embodiment shown includes a microcontroller. The microcontroller may be connected to the outlet of the computing/electronic module for controlling transistors Q1, Q2. Transistors Q1, Q2 may be controlled alternatively by the microcontroller in a pulse width modulation (PWM) mode, for example with a 90° phase shift.

The computing/electronic module further includes a number of condensers C1, C2. Condensers C1, C2 are provided in the secondary windings of transformer T1. Condensers C1, C2 allow decoupling between the signal of pilot current P and possible potentials in the fuse or contact 10 to be diagnosed.

The computing/electronic module further includes filters Rout, R, C3 intended to adapt the output signal Vout that is being sent to a remote microcontroller (not shown).

The present diagnosing device 100 is provided with means for assessing the pilot current P adapted to assess a pilot current that is a replica of the pilot current through the contact 10 to be diagnosed, through the transformer ratio. If a threshold maximum value of such impedance is detected, the diagnosing device 100 provides an indication that the contact is in an off condition, otherwise in an on condition. In the example shown, for diagnosing contact 10, transistors Q1, Q2 are alternatively triggered in a pulse width modulation mode with a 90° phase shift. The condition of contact 10 is identified by output signal Vout which phase shift is read by the remote microntroller (not shown). If contact 10 is determined to be in an off condition (open contact or blown fuse) current i2 through the secondary windings of the transformer T1 is 0 and current i1 on the primary windings of the transformer is 0 (transformation ratio). Output voltage is thus Vout= i1 . Rout = 0. If contact 10 is determined to be in an on condition (closed contact or operating fuse) current i2 through the secondary windings of the transformer is I2 and current i1 through the primary windings of the transformer is I1 (transformation ratio). Output voltage is Vout= i1 · Rout.

Although only a number of particular embodiments and examples of the present diagnosing device and electromechanical assembly have been disclosed herein, it will be understood by those skilled in the art that other alternative embodiments, uses and obvious modifications and equivalents thereof are possible.

The present disclosure covers all possible combinations of the particular embodiments of the present diagnosing device and electromechanical assembly described.

Reference signs related to drawings and placed in parentheses in a claim, are solely for attempting to increase the intelligibility of the claim, and shall not be construed as limiting the scope of the claim. Thus, the scope of the present disclosure should not be limited by particular embodiments, but should be determined only by a fair reading of the claims that follow.

## Claims

1. A device (100) for diagnosing the condition of a fuse or a contact (10) in a contactor, the device (100) comprising a current generator (50) adapted to deliver a pilot current (P) through the fuse or contact (10) to be diagnosed, and a computing/electronic module for verifying if the delivered pilot current (P) flows through the fuse or contact (10)
**characterized in that** the computing/electronic module comprises:
- a first sub-module comprising a transformer (T1) adapted to separate potentials between the fuse or contact (10) to be diagnosed and the computing/electronic module;
- a second sub-module connected to the first sub-module and adapted for the activation of the transformer (T1) with a suitable waveform through a set of transistors (Q1, Q2); and
- a third sub-module connected to the first sub-module and adapted for decoupling the delivered pilot current (P) and possible electrical potentials associated with the fuse or contact (10) to be diagnosed.

2. The device (100) as claimed in claim 1, wherein the set of transistors (Q1, Q2) of the second sub-module is provided in the primary windings of the transformer (T1).

3. The device (100) as claimed in any of the preceding claims, wherein the third sub-module comprises at least one condenser (C1, C2) provided in the secondary windings of the transformer (T1).

4. The device (100) as claimed in any of the preceding claims, wherein the current generator (50) is arranged such that the supply of the pilot current (P) reflected at the primary side of the transformer (T1) is suitably isolated from the supply of main current (M) to the fuse or contact (10).

5. The device (100) as claimed in any of the preceding claims, wherein it further includes a microcontroller connected to the outlet of the computing/electronic module for controlling the transistors (Q1, Q2).

6. The device (100) as claimed in claim 5, wherein the microcontroller is capable of controlling the transistors (Q1, Q2) alternatively.

7. The device (100) as claimed in claim 6, wherein the microcontroller is capable of controlling the transistors (Q1, Q2) in a pulse width modulation (PWM) mode.

8. The device (100) as claimed in claim 7, wherein the PWM mode is carried out with a 90° phase shift.

9. The device (100) as claimed in any of the preceding claims, wherein the computing/electronic module comprises at least one selected from an electronic module, a computing module and a logic gate module.

10. An electromechanical assembly comprising the device (100) for diagnosing the condition of a fuse or a contact (10) in a contactor according to any of the preceding claims.

## Patentansprüche

1. Eine Vorrichtung (100) zur Prüfung von einem Zustand einer Schmelzsicherung oder eines Kontakts (10) in einem Schaltschütz, wobei die Vorrichtung (100) einen Konstantstromerzeuger (50) umfasst, der angepasst ist, um einen Steuerstrom (P) durch die zu prüfende Schmelzsicherung oder den zu prüfenden Kontakt (10) zu versorgen, und ein Rechensmodul/elektronisches Modul zur Überprüfung dessen umfasst, ob der versorgte Steuerstrom (P) durch die Schmelzsicherung oder den Kontakt (10) fließt
**dadurch gekennzeichnet, dass** das Rechensmodul/elektronische Modul folgendes umfasst:
- ein erstes Teilmodul umfassend einen Transformator (T1), der angepasst ist, um Spannungen zwischen der zu prüfenden Schmelzsicherung oder dem zu prüfenden Kontakt (10) und dem Rechensmodul/elektronischen Modul zu trennen;
- ein zweites Teilmodul (T1), das mit dem ersten Teilmodul verbunden ist und zur Aktivierung des Transformators (T1) mit einer geeigneten Wellenform durch eine Reihe von Transistoren (Q1, Q2) angepasst ist; und
- ein drittes Teilmodul, das mit dem ersten Teilmodul verbunden ist und angepasst zur Entkopplung des versorgten Steuerstroms (P) und etwaigen Spannungen ist, die mit der zu prüfenden Schmelzsicherung oder dem zu prüfenden Kontakt (10) verknüpft sind.

2. Die Vorrichtung (100) wie in Anspruch 1 beansprucht, wobei die Reihe von Transistoren (Q1, Q2) des zweiten Teilmoduls in den Primärwicklungen des Transformators (T1) bereitgestellt ist.

3. Die Vorrichtung (100) wie in einem der vorhergehenden Ansprüche beansprucht, wobei das dritte Teilmodul mindestens einen in den Sekundärwicklungen des Transformators (T1) bereitgestellten Kondensator (C1, C2) umfasst.

4. Die Vorrichtung (100) wie in einem der vorhergehenden Ansprüche beansprucht, wobei der Konstantstromerzeuger (50) derart angeordnet ist, dass die Versorgung vom Steuerstrom (P), der an der Primärseite des Transformators (T1) reflektiert wird, zweckmäßig von der Versorgung der Schmelzsicherung oder des Kontakts (10) mit Hauptstrom (M) isoliert ist.

5. Die Vorrichtung (100) wie in einem der vorhergehenden Ansprüche beansprucht, wobei sie weiterhin einen mit dem Ausgang des Rechensmoduls/elektronischen Moduls verbundenen Mikrokontroller zur Kontrolle der Transistoren (Q1, Q2) umfasst.

6. Die Vorrichtung (100) wie in Anspruch 5 beansprucht, wobei der Mikrokontroller die Transistoren (Q1, Q2) wechselweise steuern kann.

7. Die Vorrichtung (100) wie in Anspruch 6 beansprucht, wobei der Mikrokontroller die Transistoren (Q1, Q2) in einem auf Pulsdauermodulation (PDM) beruhenden Modus steuern kann.

8. Die Vorrichtung (100) wie in Anspruch 7 beansprucht, wobei der auf PDM beruhende Modus mit einem Phasenverschiebung von 90° durchgeführt wird.

9. Die Vorrichtung (100) wie in einem der vorhergehenden Ansprüche beansprucht, wobei das Rechensmodul/elektronische Modul mindestens ein Modul ausgewählt aus einem elektronischen Modul, einem Rechensmodul und einem Gattermodul umfasst.

10. Eine elektromechanische Anordnung umfassend die Vorrichtung (100) zur Prüfung des Zustands von einer Schmelzsicherung oder einem Kontakt (10) in einem Schaltschütz nach einem der vorhergehenden Ansprüche.

## Revendications

1. Un dispositif (100) pour le diagnostic de l'état d'un fusible ou d'un contact (10) dans un contacteur, le dispositif (100) comprenant un générateur de courant (50) adapté pour alimenter un courant pilote (P) à travers le fusible o le contact (10) dont le diagnostic doit être réalisé, et un module de calcul/électronique pour vérifier si le courant pilote (P) alimenté circule à travers le fusible ou le contact (10)
**caractérisé en ce que** le module de calcul/électronique comprend :
- un premier sous-module comprenant un transformateur (T1) adapté pour séparer des potentiels entre le fusible ou le contact (10) dont le diagnostic doit être réalisé et le module de calcul/électronique ;
- un second sous-module connecté au premier sous-module et adapté pour l'activation du transformateur (T1) avec une forme d'onde moyennant une série de transistors (Q1, Q2) ; et
- un troisième sous-module connecté au premier sous-module et adapté pour découpler le courant pilote (P) alimenté et de possibles potentiels électriques liés au fusible ou au contact (10) dont le diagnostic doit être réalisé.

2. Le dispositif (100) tel que revendiqué dans la revendication 1, dans lequel la série de transistors (Q1, Q2) du second sous-module est fournie dans les enroulements primaires du transformateur (T1).

3. Le dispositif (100) tel que revendiqué dans l'une quelconque des revendications précédentes, dans lequel le troisième sous-module comprend au moins un condensateur (C1, C2) fourni dans les enroulements secondaires du transformateur (T1).

4. Le dispositif (100) tel que revendiqué dans l'une quelconque des revendications précédentes, dans lequel le générateur de courant (50) est disposé de façon que l'alimentation en courant pilote (P) réfléchie dans le côté primaire du transformateur (T1) est isolée de manière appropriée par rapport à l'alimentation du fusible ou du contact (10) en courant principal (M).

5. Le dispositif (100) tel que revendiqué dans l'une quelconque des revendications précédentes, incluant en outre un microcontrôleur connecté à la sortie du module de calcul/électronique pour contrôler les transistors (Q1, Q2).

6. Le dispositif (100) tel que revendiqué dans la revendication 5, dans lequel le microcontrôleur est capable de contrôler les transistors (Q1, Q2) alternativement.

7. Le dispositif (100) tel que revendiqué dans la revendication 6, dans lequel le microcontrôleur est capable de contrôler les transistors (Q1, Q2) dans un mode de modulation de largeur d'impulsions (MLI).

8. Le dispositif (100) tel que revendiqué dans la revendication 7, dans lequel le mode de MLI est effectué avec un décalage de phases de 90°.

9. Le dispositif (100) tel que revendiqué dans l'une quelconque des revendications précédentes, dans lequel le module de calcul/électronique comprend au moins un module choisi parmi un module électronique, un module de calcul et un module de fonctions logiques.

10. Une unité électromagnétique comprenant le dispositif (100) pour le diagnostic de l'état d'un fusible ou d'un contact (10) dans un contacteur selon l'une quelconque des revendications précédentes.
